# EUROPEAN PATENT APPLICATION

(11) **EP 2 560 203 A1**
(43) Date of publication of application: **20.02.2013**
(21) Application number: 12179207.1
(22) Date of filing: 03.08.2012
(51) Int. Cl.: H01L 23/62, H01L 25/07, H01L 23/051, H01L 23/492, H01L 23/48

(54) **Power semiconductor arrangement**

(30) Priority: 17.08.2011 EP 11177801
(71) Applicant: ABB Technology AG, 8050 Zürich (CH)
(72) Inventor: Franc, Dugal, 8702 Zollikon (CH)
(74) Representative: ABB Patent Attorneys

(57) **Abstract**

The present invention provides a power semiconductor arrangement (1) comprising a base plate (2) comprising a molybdenum layer (4), and a power semiconductor device (3) mounted to a top side of the base plate (2) and electrically and thermally coupled thereto, whereby the base plate (2) comprises a metallic mounting base (6), which is arranged between the semiconductor device (3) and the molybdenum layer (4) and prevents the molybdenum layer (4) from forming highly resistive intermetallic phases with the semiconductor device (3). The present invention further provides a power semiconductor module, with multiple power semiconductor arrangements, whereby the base plate (2) of the power semiconductor arrangements (1) is a common base plate (2). The present invention also provides a module assembly, especially a power semiconductor module assembly, comprising multiple power semiconductor modules, whereby the power semiconductor modules are arranged side by side to each other with electric connections between adjacent semiconductor modules.

## Description

### Technical Field

The present invention relates to a power semiconductor arrangement, comprising a base plate comprising a molybdenum layer, and a power semiconductor device mounted to a top side of the base plate and electrically and thermally coupled thereto. The present invention further relates to a power semiconductor module with multiple power semiconductor arrangements. The present invention also relates to a module assembly, especially a power semiconductor module assembly, comprising multiple power semiconductor modules.

### Background Art

Power semiconductor arrangements of the afore-mentioned kind are well-known in the art and are e.g. used in the area of mounting and contacting power semiconductor devices as well as high power semiconductors. These power semiconductors devices may deal with voltages of about 1.7 kV or higher and are mounted to the base plate by means of bonding, soldering or others. The base plate in these power semiconductor arrangements is in surface contact with one side of the power semiconductor device, so that current can be provided from the base plate directly to the power semiconductor device. The surface contact between the power semiconductor device and the base plate enables heat transfer away from the power semiconductor. In order to keep the power semiconductor device at a desired working temperature, coolers can be connected to the base plate as heat sinks. Accordingly, the power semiconductor device is thermally and electrically coupled to the base plate. Typical power semiconductor devices used in this area are insulated gate bipolar transistors (IGBT), reverse conducting insulated gate bipolar transistors (reverse conducting IGBT), bi-mode insulated gate transistors (BIGT) or (power) diodes.

Such power semiconductor arrangements are frequently combined, e.g. for forming a power semiconductor module, which can deal with currents of up to 100 A and higher. The power semiconductor arrangements are arranged in parallel on a common base plate, which usually forms an electrically conducting base of the power semiconductor module. The power semiconductor module is usually covered by an electrically conducting lid, which provides a further contact for the power semiconductor devices. The power semiconductor devices are usually connected to the electrically conducting lid by means of presspins, which are known in the art.

A presspin comprises a foot and a head, which are movable relative to each other along a longitudinal axis of the presspin and which are electrically interconnected, for example by a current bypass. Between the foot and the head a spring element is arranged, which exerts an outwardly directed force on the foot and the head for pushing them against contact elements of the power semiconductor devices and opposed contacts, e.g. a lid of a housing, to maintain electric connection there between. The spring element may be a spring washer pack, but other spring elements may be used as well. The contact between the foot and the respective contact element is provided via a base of the foot. Typically such presspins are used to contact gate or control contacts, collector contacts and / or emitter contacts.

Multiple power semiconductor modules can further be combined to form a module assembly, especially a power semiconductor module assembly. The power semiconductor modules are arranged side by side to each other with electric connections between adjacent power semiconductor modules. The module assembly can comprise identical power semiconductor modules, e.g. semiconductor modules comprising power transistors, or different power semiconductor modules, e.g. a set of semiconductor modules comprising power transistors and at least one semiconductor module comprising power diodes. Such module assemblies are e.g. known as "Stakpak" from the applicant and can be used for forming stacked arrangements as used for example in HVDC applications. Accordingly, the mechanical design of the module assembly is optimized in order to facilitate clamping in long stacks.

In such power semiconductor modules and power module assemblies, support of a short circuit failure mode (SCFM) of the individual power semiconductor devices is an essential feature. In case one of the power semiconductor devices fails, it fails by providing a short circuit to enable conduction from the base plate to the lid. Accordingly, when multiple of the power semiconductor modules or the module assemblies are connected in series, e.g. forming a stack, failure of a single power semiconductor device does not lead to a failure of the series of the power semiconductor modules or the module assemblies.

Especially in this short circuit failure mode, very high currents can flow through a single power semiconductor device, since the short circuit disables all parallel power semiconductor devices. To achieve a high life time of these power semiconductor devices and accordingly a high life time of the power semiconductor modules and the module assemblies, it is desired that the short circuit failure mode can be maintained for a year or even more. Accordingly, the contact of the power semiconductor and the base plate has to be able to deal for a prolonged time with substantial heat due to the short circuit current. To provide good conduction in short circuit failure mode, it is known in the art to provide a small platelet containing aluminum over the semiconductor device. When the power semiconductor device fails and the short circuit current raises the temperature, the aluminum melts and forms an alloy with the silicon of the power semiconductor device. This AlSi alloy has a relatively good electrical and thermal conduction. Nevertheless, aging of the contact between the base plate and the failed power semiconductor device can increase electrical resistance up to a point that it is high enough to break another power semiconductor device, so that the problem is propagated through the entire power semiconductor module and the entire module assembly. Especially in the area of power and high power semiconductors, this is a very critical, since large amounts of energy are present and arcing can occur within the power semiconductor module. Worst case, even neighbouring cooler damages can occur or a failure of the entire system.

Investigation has shown that a main reason for electric contact aging and failure is the formation of particularly two highly resistive intermetallic phases between the semiconductor device and the base plate. The term "highly resistive" refers to the resistance compared to a "normal" resistance of a contact between the power semiconductor device and the base plate, e.g. when AlSi is formed at the contact in SCFM. These phases are particularly Mo(SiAl)₂ and MoSi₂, which reduce the electrical and thermal conductivity between the power semiconductor device and the base plate. Accordingly, the contact temperature increases and the SCFM life time is reduced.

Intents to use a base plate made of pure copper or pure aluminium have resulted in an increased life time of the power semiconductor arrangement, especially in short circuit failure mode, since the formation of the above-mentioned intermetallic phases is prevented. Nevertheless, the use of these base plates resulted in major problems due to the different coefficient of thermal expansion of aluminium or copper compared to silicon. Changes in the temperature of the power semiconductor arrangement result in shearing forces at the connection between the power semiconductor device and the base plate, so that the stability of the connection between the power semiconductor device and the base plate is reduced over the time. This limits the thermal cycling capacity, which is a major problem in the area of semiconductor devices, especially power semiconductor devices.

Another problem occurring in these power semiconductor arrangements is the problem of overheating of the power semiconductor device and heat transfer away from the semiconductor device. Especially in power semiconductor devices, it is important to provide a reliable cooling mechanism, so that the semiconductor device can be operated at a desired working temperature or at least below a maximum temperature. Cooling is frequently realized by heat transfer from the semiconductor device to the base plate, which further transfers the heat to a cooling mechanism, e.g. a cooler attached thereto. The heat transfer away from the semiconductor device is a limiting factor in chip design, especially when referring to power semiconductor devices. Accordingly, improvements are also required in this area.

### Disclosure of Invention

It is an object of the present invention to provide a power semiconductor arrangement, a power semiconductor module with multiple power semiconductor arrangements, and a module assembly comprising multiple power semiconductor modules, which have a long lifetime of the electrical and thermal connection between the power semiconductor device and the base plate and provide good heat transfer away from the power semiconductor device, especially in short circuit failure mode.

This object is achieved by the independent claims. Advantageous embodiments are given in the dependent claims.

In particular, the present invention provides a power semiconductor arrangement, comprising a base plate comprising a molybdenum layer, and a power semiconductor device mounted to a top side of the base plate and electrically and thermally coupled thereto, whereby the base plate comprises a metallic mounting base, which is arranged between the semiconductor device and the molybdenum layer and prevents the molybdenum layer from forming highly resistive intermetallic phases with the semiconductor device. Further, a presspin is arranged next to the power semiconductor device on the opposite side of the base plate.

Basic idea of the invention is to provide an intermediate mounting base between the power semiconductor device and the molybdenum layer, so that the silicon of the power semiconductor device and the molybdenum of the molybdenum layer cannot form highly resistive intermetallic phases, such as Mo(SiAl)₂ and MoSi₂,. The use of a metallic material is important to maintain electric and thermal conductivity, so that the normal operation of the power semiconductor arrangement is not limited. Metallic materials having a good conductivity for current and heat are preferred. The coefficient of thermal expansion of the molybdenum of the molybdenum layer limits problems also provides a suitable thermal cycling capacity.

The object of the present invention is also solved by a power semiconductor module with multiple semiconductor arrangements as described above, whereby the base plate of the power semiconductor arrangements is a common base plate. Accordingly, a single base plate can be used as a basis for mounting several power semiconductor devices thereon, usually in a parallel manner, so that the power semiconductor module is easy to handle. Multiple power semiconductor devices can be contacted easily by merely contacting the common base plate of the power semiconductor module.

The object of the present invention is also solved by a module assembly, especially a power semiconductor module assembly, comprising multiple power semiconductor modules as described above, whereby the power semiconductor modules are arranged side by side to each other with electric connections between adjacent semiconductor modules. Multiple module assemblies can be contacted easily by merely contacting the module assembly. The module assembly can comprise identical semiconductor modules, e.g. semiconductor modules comprising power transistors like insulated gate bipolar transistors (IGBT), reverse conducting insulated gate bipolar transistors (reverse conducting IGBT) or bi-mode insulated gate transistors (BIGT), or different power semiconductor modules, e.g. a set of power semiconductor modules comprising power transistors and at least one power semiconductor module comprising power diodes. Such module assemblies can be used for forming stacked arrangements as used for example in HVDC applications.

According to a preferred embodiment of the present invention the mounting base is made of copper. In alternative embodiments of the present invention, the mounting base is made of an alloy based on copper. Since copper shows a good thermal and electric conductivity, it is suitable to be used without limiting the operation of the power semiconductor arrangement. This also applies to alloys based on copper, especially to alloys having similar characteristics like copper in respect to electrical and thermal conduction. Alloys additionally containing silver are preferred.

According to a preferred embodiment of the present invention the mounting base supports the formation of a short-circuit failure mode in case of failure of the power semiconductor device.

According to a preferred embodiment of the present invention a platelet is arranged between the power semiconductor device and the presspin. The platelet may be made of copper, aluminum, silver, gold and / or an alloy thereof. The platelet may help to form the short circuit failure mode.

According to a preferred embodiment of the present invention the mounting base is provided as a mounting plate with a surface area bigger than the surface area of the power semiconductor device. The increased size of the mounting base compared to the size of the power semiconductor device improves the cooling of the power semiconductor, since heat can be dissipated via the mounting plate and then be transferred to the molybdenum layer of the base plate. Heat transfer characteristics of copper or copper based alloys are usually better than heat transfer characteristics of molybdenum. Accordingly, the performance of the power semiconductor device can be improved due to improved cooling.

According to a preferred embodiment of the present invention the mounting base is provided as a mounting layer extending over the molybdenum layer. This facilitates the production of the base plate, since the mounting base can be applied in a single production process over the entire surface of the molybdenum layer. Also, base plates can be provided without having to deal with a particular design of a power semiconductor arrangement. Accordingly, mass production can be performed at low costs.

According to a preferred embodiment of the present invention the mounting layer is laminated to the molybdenum layer. Laminating is a manufacturing process, which can be performed easily and rapidly and therefore allows of the provisioning of base plates at low manufacturing costs. Nevertheless, also other process steps can be applied for connecting the molybdenum layer and the mounting layer, e.g. bonding, or soldering.

According to a preferred embodiment of the invention the base plate comprises a base layer, which is provided on the molybdenum layer opposite to the mounting layer, whereby the base layer has a thermal expansion coefficient essentially equal to the thermal expansion coefficient of the mounting layer. The base layer allows providing the base plate having a sandwich structure, which prevents bending due to different thermal expansion coefficients of the materials of the molybdenum layer and the mounting layer. The base layer provides a bending force in a direction opposite to the bending force of the mounting layer, so that the base plate remains in a planar shape, even when it undergoes temperature changes. This allows the use of big base plates without the danger of bending. Additionally, the base layer improves cooling of the power semiconductor, especially when the thermal coefficient of the material of the base layer is higher than the thermal coefficient of the molybdenum layer. Accordingly, heat dissipation and transfer of the base plate can be improved.

According to a preferred embodiment the base layer and the mounting layer are provided as identical layers. The base plate can be easily manufactured, since only one material has to be provided for the base layer and the mounting layer, which can be processed by a single processing step. The use of identical layers also provides the base plate with a uniform sandwich structure, which further reduces the possibilities of bending due to thermal expansion of different materials of the base layer and the mounting layer one the one hand-side and the molybdenum layer on the other hand-side.

According to a preferred embodiment of the invention, the thickness of the molybdenum layer is at least 3 times higher than the thickness of the mounting plate or mounting layer, preferably the thickness of the molybdenum layer is 3 to 10 times higher, even more preferably 5 to 6 times higher than the thickness of the mounting plate or mounting layer. This thickness relation has shown good performance in practical tests. First, a good cycling capacity is achieved despite the different thermal expansion of the materials of the mounting plate/layer and the molybdenum layer. Second, a good heat transfer and dissipation from the power semiconductor to the molybdenum layer is achieved. In absolute values, a thickness of the mounting layers of 0.2 mm is an example for a suitable value. In case a base layer is connected to the molybdenum layer, the thickness relation between the mounting plate/mounting layer, the molybdenum layer and the base layer is preferably 1:3:1 to 1:10:1, even more preferably 1:5:1 to 1:6:1, thereby forming a uniform sandwich structure of the base plate. Since the thickness of the mounting plate/mounting layer and the base layer is equal, bending due to thermal expansion of the different materials can be avoided.

According to a preferred embodiment of the invention, the thickness of the molybdenum layer is between 1mm and 10mm. Such a thickness of the molybdenum layer provides a good stability of the base plate. Also good heat transfer away from the power semiconductor device can be achieved.

According to a preferred embodiment of the power semiconductor module of the invention, the power semiconductor module comprises a housing, whereby an electrically conducting lid forms a top side of the housing and provides a first contact of the power semiconductor module, the common base plate forms a base of the housing and provides a second contact of the power semiconductor module, and the power semiconductor devices are in electric contact with the lid. Preferably, presspins are provided between the power semiconductor devices and the lid for providing the electrical contact. Generally speaking, the lid provides a first contact of the power semiconductor module for contacting first contacts of the power semiconductor devices, and the base plate provides a second contact of the power semiconductor module for contacting second contacts of the semiconductor devices. When power transistors are used as power semiconductor devices, usually the base plate is connected to the collector of the power transistors and the emitter of the power transistors is connected to the lid. The gates of the power transistors are also commonly connected within the power semiconductor module, and can be contacted e.g. through a spare in the lid or by a lateral contact.

According to a preferred embodiment of the module assembly of the invention, the base plates of the power semiconductor modules are electrically connected to each other. The connection can be made by wiring or by providing a contact plate for contacting the base plates of the power semiconductor modules.

According to a preferred embodiment of the module assembly of the invention, the module assembly comprises a housing, whereby the common base plates of the power semiconductor modules extend through a base of the housing, and an electrically conducting lid forms a top side of the housing and provides a common contact for the power semiconductor modules. Generally speaking, the lid provides a first contact of the module assembly for contacting the first contacts of the semiconductor modules and the base plate provides a second contact of the module assembly for contacting the second contacts of the power semiconductor modules. The gate contacts of the power semiconductor modules are also commonly contacted in the module assembly and are connected to a lateral contact of the module assembly or can be contacted through a spare in the lid.

### Brief Description of Drawings

These and other aspects of the invention will be apparent from and elucidated with reference to the embodiments described hereinafter.

In the drawings:

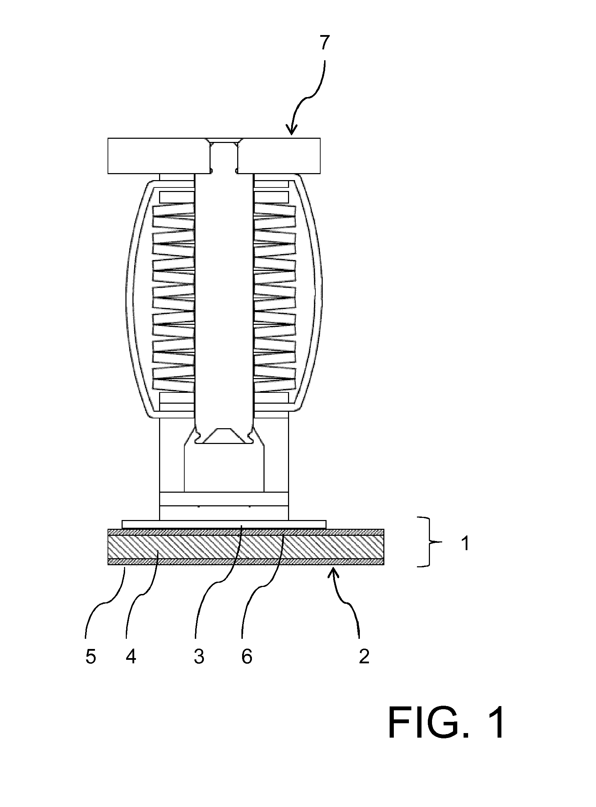

Fig. 1 shows a sectional view of a power semiconductor arrangement of a power semiconductor module with multiple power semiconductor arrangements, whereby a power semiconductor device of the power semiconductor arrangement is contacted by a press pin.

### Detailed Description of the Invention

Fig. 1 shows a power semiconductor arrangement 1 according to the present invention. The power semiconductor arrangement 1 comprises a base plate 2 and a power semiconductor device 3. The base plate 2 is a laminated plate comprising a central molybdenum layer 4, which is sandwiched between a base layer 5 and a mounting layer 6. The thickness of the molybdenum layer 4 is according to this exemplary embodiment of the invention approximately 5 mm.

The power semiconductor device 3 in this exemplary embodiment of the present invention is a power power semiconductor device, particularly an IGBT, and can be used for voltages up to 1.7 kV or higher. It is mounted on a top side of the mounting layer 6 and thereby electrically and thermally coupled thereto. The power semiconductor device 3 is contacted on its upper side, which lies opposite to the base plate 2, by a presspin 7. Since presspins 7are known in the art, further details in respect to the presspin 7 are not given here. The mounting layer 6 serves as mounting base for the power semiconductor 3, whereby the extension of the mounting layer 6 is bigger than the surface area of the power semiconductor.

The mounting layer 6 and the base layer 5 are both made of copper and are laminated to the molybdenum layer 4. The thickness of the mounting layer 6 and the base layer 5 is 1 mm in this exemplary embodiment of the present invention. Accordingly, the thickness relation between the mounting layer 6, the molybdenum layer 4 and the base layer 5 is 1:5:1 in this exemplary embodiment of the present invention. The base layer 5 and the mounting layer 6 extend over the entire surface of the molybdenum layer 4 on the respective side thereof. Accordingly, the layers 5, 6 are equally provided on both sides of the molybdenum layer 4 and the thermal expansion of the layers 5, 6 compensates each other. Therefore, even in thermal cycles involving heating and/or cooling, the base plate 2 remains in a planar shape.

Since the base plate 2 is provided with the mounting layer 6 on the top side of the molybdenum layer 4, the power semiconductor device 3 and the molybdenum layer 4 are not in direct contact. Accordingly, the formation of intermetallic phases, particularly Mo(SiAl)₂ and MoSi₂, between the molybdenum of the molybdenum layer 4 and the silicon of the power semiconductor device 3 is reliably prevented.

The power semiconductor arrangement 1 of Fig. 1 forms part of a power semiconductor module, which comprises multiple power semiconductor arrangements 1 as described above. Details of the power semiconductor module are not shown in the figure. The base plate 2 of the power semiconductor arrangements 1 is a common base plate 2, where all power semiconductors devices 3 are mounted on. In this exemplary embodiment of the present invention, the multiple power semiconductor devices 3 are arranged in parallel to each other on the base plate 2 and form a power semiconductor module.

The power semiconductor module comprises a housing, whereby the common base plate 2 forms a base of the housing. An electrically conducting lid forms a top side of the housing. The lid provides a first contact of the power semiconductor module and the base plate 2 provides a second contact of the power semiconductor module. The power semiconductor devices 3 are in electric contact with the lid by means of presspins 7, which are provided between the power semiconductor devices and the lid for providing electrical contact there between. The base plate 2 is connected to the collectors of the power semiconductor devices 3 and the emitters of the power semiconductor devices 3 are connected to the lid. The gates of the power semiconductor devices 3 are also commonly contacted in the power semiconductor module through a spare in the lid.

A power semiconductor module assembly comprises multiple power semiconductor modules as described above. Details of the module assembly are not shown in the figure. The power semiconductor modules are arranged side by side to each other within a housing, whereby the common base plates 2 of the power semiconductor modules extend through a base of the housing. An electrically conducting lid forms a top side of the housing and provides a common contact for the power semiconductor modules with electric connections between adjacent semiconductor modules. The lid provides a first contact of the module assembly for contacting the first contacts of the power semiconductor modules and the base plate provides a second contact of the module assembly for contacting the second contacts of the power semiconductor modules. The gate contacts of the power semiconductor modules are connected to each other within the module assembly and are connected to a lateral contact of the module assembly.

The module assembly comprises different power semiconductor modules, in this exemplary embodiment of the invention a set of power semiconductor modules comprising power transistors and at least one power semiconductor module comprising power diodes. The module assembly is used for forming a stacked arrangement in a HVDC application.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or " an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: Power semiconductor arrangement
- 2: base plate
- 3: power semiconductor device
- 4: molybdenum layer
- 5: base layer
- 6: mounting layer
- 7: presspin

## Claims

1. Power semiconductor arrangement (1), comprising
a base plate (2) comprising a molybdenum layer (4), and
a power semiconductor device (3) mounted to a top side of the base plate (2) and electrically and thermally coupled thereto, and
a presspin, which is arranged next to the power semiconductor device on the opposite side of the base plate (2),
**characterized in that**
the base plate (2) comprises a metallic mounting base (6), which is arranged between the semiconductor device (3) and the molybdenum layer (4) and prevents the molybdenum layer (4) from forming highly resistive intermetallic phases with the semiconductor device (3).

2. Semiconductor arrangement (1) according to preceding claim 1,
**characterized in that**
the mounting base (6) is made of copper.

3. Semiconductor arrangement (1) according to preceding claim 1,
**characterized in that**
the mounting base (6) is made of an alloy based on copper.

4. Semiconductor arrangement (1) according to any of the preceding claims 1 to 3,
**characterized in that**
the mounting base (6) supports the formation of a short-circuit failure mode in case of failure of the power semiconductor device (3).

5. Semiconductor arrangement (1) according to any of the preceding claims 1 to 4,
**characterized in that**
a platelet is arranged between the power semiconductor device and the presspin, which platelet is made of copper, aluminum, silver, gold and/or magnesium or an alloy thereof.

6. Semiconductor arrangement (1) according to any of preceding claims 1 to 5,
**characterized in that**
the mounting base (6) is provided as a mounting plate with a surface area bigger than the surface area of the semiconductor device (3).

7. Semiconductor arrangement (1) according to any of preceding claims 1 to 6,
**characterized in that**
the mounting base (6) is provided as a mounting layer extending over the molybdenum layer (4).

8. Semiconductor arrangement (1) according to preceding claim 7,
**characterized in that**
the mounting layer (6) is laminated to the molybdenum layer (4).

9. Semiconductor arrangement (1) according to any of preceding claims 7 or 8,
**characterized in that**
the base plate (2) comprises a base layer (5), which is provided on the molybdenum layer (4) opposite to the mounting layer (6), whereby the base layer (5) has a thermal expansion coefficient essentially equal to the thermal expansion coefficient of the mounting layer (6).

10. Semiconductor arrangement (1) according to preceding claim 9,
**characterized in that**
the base layer (5) and the mounting layer (6) are provided as identical layers.

11. Semiconductor arrangement (1) according to any of preceding claims 6 to 10,
**characterized in that**
the thickness of the molybdenum layer (4) is at least 3 times higher than the thickness of the mounting plate or mounting layer (6), preferably the thickness of the molybdenum layer (4) is 3 to 10 times higher, even more preferably 5 to 6 times higher than the thickness of the mounting plate or mounting layer (6).

12. Semiconductor arrangement (1) according to any of preceding claims 6 to 11,
**characterized in that**
the thickness of the molybdenum layer (4) is between 1mm and 10mm.

13. Power semiconductor module with multiple power semiconductor arrangements (1) according to any of the preceding claims,
**characterized in that**
the base plate (2) of the power semiconductor arrangements (1) is a common base plate (2).

14. Power semiconductor module according to preceding claim 13,
**characterized in that**
the power semiconductor module comprises a housing, whereby
an electrically conducting lid forms a top side of the housing and provides a first contact of the power semiconductor module,
the common base plate (2) forms a base of the housing and provides a second contact of the power semiconductor module, and
the presspin of each power semiconductor arrangement (1) is arranged between the power semiconductor device (3) of the power semiconductor arrangement (1) and the lid,
the power semiconductor devices (3) are in electric contact with the lid.

15. Module assembly, especially a power semiconductor module assembly, comprising multiple power semiconductor modules according to any preceding claim 13 or 14,
**characterized in that**
the power semiconductor modules are arranged side by side to each other with electric connections between adjacent semiconductor modules.

16. Module assembly according to preceding claim 15,
**characterized in that**
the base plates (2) of the power semiconductor modules are electrically connected to each other.

17. Module assembly according to any preceding claim 15 or 16,
**characterized in that**
the module assembly comprises a housing, whereby
the common base plates (2) of the power semiconductor modules extend through a base of the housing, and
an electrically conducting lid forms a top side of the housing and provides a common contact for the power semiconductor modules.
